# FASCICULE DE BREVET EUROPEEN

(11) **EP 1 497 857 B1**
(45) Date de publication et mention de la délivrance du brevet: **19.05.2010**
(21) Numéro de dépôt: 03727614.4
(22) Date de dépôt: 26.03.2003
(51) Int. Cl.: H01L 21/58, H01L 21/68, H01L 21/762, H01L 21/20

(54) **PROCEDE DE MANIPULATION DE COUCHES SEMICONDUCTRICES POUR LEUR AMINCISSEMENT**
VERFAHREN ZUR MANIPULATION VON HALBLEITERSCHICHTEN ZUM DÜNNMACHEN DERSELBEN
METHOD FOR HANDLING SEMICONDUCTOR LAYERS IN SUCH A WAY AS TO THIN SAME

(30) Priorité: 28.03.2002 FR 0203909
(43) Date de publication de la demande: 19.01.2005
(73) Titulaire: Commissariat à l'énergie atomique et aux énergies alternatives, 75015 Paris (FR)
(72) Inventeur: ASPAR, Bernard, F-38140 RIVES (FR); ZUSSY, Marc, 38120 Saint- Egreve (FR); CLERC, Jean-Frédéric, F-38320 BRIE ET ANGONNES (FR)
(74) Mandataire: Poulin, Gérard
(86) Numéro de dépôt international: PCT/FR2003/000954
(87) Numéro de publication internationale: WO 2003/083930

(56) Documents cités:
- FR-A- 2 767 604
- FR-A- 2 781 925
- FR-A- 2 809 867
- US-A1- 2001 051 415

## Description

### DOMAINE TECHNIQUE

Les besoins en composants électroniques dont l'épaisseur est très faible (entre quelques µm et quelques dizaines de µm) sont de plus en plus importants. En effet, ces composants ultra-minces présentent un certain nombre d'avantages dont les principaux sont le faible encombrement et la grande souplesse d'utilisation. De tels composants électroniques peuvent par exemple être intégrés sur des supports en plastique ou en papier. Le domaine d'application tout d'abord visé est celui des cartes à puce et des étiquettes électroniques. Les composants électroniques ultra-minces sont également de plus en plus demandés dans des domaines comme l'encapsulation afin d'obtenir des circuits dans des boîtiers ultra-plats.

Ces composants ultra-minces sont également indispensables pour réaliser des circuits intégrés verticalement ou circuits 3D. Le report d'un circuit ultra-mince sur un autre circuit permet d'augmenter ainsi la densité d'intégration. Les applications de ces circuits 3D concernent les nouveaux systèmes intégrés de puissance, la radio-fréquence, l'optoélectronique et également le domaine des microprocesseurs.

Il est également important de pouvoir obtenir des composants de type microsystème (au sens large MEMS pour "Micro-Electro-Mechanical Systems" ou MOEMS pour "Micro-Optical-Electro-Mechanical Systems") en couche très mince pour faciliter l'intégration de ces derniers avec des composants électroniques et obtenir un système totalement intégré.

De façon générale, la couche dite active des composants microélectroniques ne fait qu'une épaisseur de quelques µm (voire moins) à quelques dizaines de µm. La partie intéressante du composant est donc réalisée uniquement en surface des plaquettes de matériau semiconducteur. Cependant, l'épaisseur du substrat joue un rôle mécanique essentiel lors de la fabrication des circuits intégrés. L'épaisseur du substrat lui confère une tenue mécanique suffisante, permet sa manipulation par des équipements automatisés standard et permet le contrôle de sa planéité pour assurer une nécessaire compatibilité avec les équipements et les procédés de photolithographie de haute résolution. En d'autres termes, une production de circuits intégrés directement sur des films de matériau semiconducteur de quelques µm d'épaisseur n'est pas envisageable.

Il est donc actuellement nécessaire d'amincir les plaquettes sur lesquelles ont été réalisés les composants.

Par ailleurs, cette nécessité d'amincissement est d'autant plus vraie que l'épaisseur des nouvelles générations de plaquettes augmente en proportion des diamètres.

Il faut donc trouver un moyen d'obtenir ces composants électroniques avec des épaisseurs très fines (typiquement inférieures à 100 µm). Un des meilleurs moyens est un moyen collectif où l'amincissement est réalisé, non pas sur un seul composant, mais sur toute la plaquette supportant les composants.

### ETAT DE LA TECHNIQUE ANTERIEURE

L'amincissement de plaques jusqu'à des épaisseurs très fines (inférieures à 100 µm) est aujourd'hui extrêmement difficile et pose des problèmes de rendement. Pour des épaisseurs aussi faibles, la plaque devient souple et souvent casse au cours de l'opération d'amincissement avant que les contraintes ne soient relaxées.

Pour remédier à cet inconvénient, il est connu de coller la plaquette à un support intermédiaire, dit poignée support, afin de pouvoir maintenir et manipuler la plaquette amincie sans la casser. Cette poignée support permet l'amincissement de la plaquette contenant les composants jusqu'à une très faible épaisseur. Après amincissement, la couche mince obtenue et qui est solidaire de la poignée support peut être manipulée et reportée sur un autre support qui peut être le support final.

Parmi les premières méthodes décrites, on peut citer les techniques publiées dans l'article "Novel LSI/SOI Wafer Fabrication Using Device Layer Transfer Technique" de T. HAMAGUCHI et al., paru dans Proc. IEDM, 1985, pages 688 à 691. Cet article mentionne l'utilisation d'une couche d'adhérence pour solidariser le substrat ou la plaquette à amincir et la poignée constituée d'une résine époxy.

D'autres techniques, basées sur le même principe, ont ensuite été développées en utilisant différents moyens de collage du substrat à amincir sur la poignée, comme par exemple des résines ou autres colles. On peut citer, à titre d'exemple, le report de couches traitées sur un support en verre par l'intermédiaire de colles UV durcissables. On peut se référer à ce sujet à l'article "An Ultra Low-Power RF Bipolar Technology on Glass" de R. DEKKER et al., paru dans IEDM 1997, pages 921 à 923.

Les techniques présentées utilisaient toutes une colle, c'est-à-dire un ajout de matière, pour solidariser le substrat à amincir sur un support qui peut être la poignée ou le support final. Cette couche additionnelle, si elle permet de fournir des forces de collage très fortes et compatibles avec un amincissement, modifie l'épaisseur de la structure. De plus, il est très difficile de contrôler l'épaisseur de colle présente et son homogénéité sur la plaque. Ces caractéristiques posent un problème dans le cas où un amincissement uniforme et précis à quelques micromètres près est nécessaire. De plus, l'utilisation de colle présente un autre problème dans le cas où l'on veut, après amincissement, reporter la couche mince sur un support final et éliminer le support intermédiaire qui sert de poignée. En effet, il faut détruire l'effet de collage, par exemple en utilisant un solvant. Deux problèmes apparaissent alors. Le premier problème est que le solvant n'est pas toujours compatible avec le support final, par exemple si le support final est une carte à puce en plastique. Le second problème est qu'il reste des résidus de colle qui sont parfois difficiles à enlever.

Il existe d'autres méthodes d'adhésion qui permettent de solidariser des plaques entre elles. Une méthode qui présente un grand avantage est la méthode de solidarisation par adhésion moléculaire ("direct wafer bonding" en anglais). Cette technique est utilisée dans de nombreux domaines pour obtenir certains substrats, par exemple des substrats SOI. On peut citer l'exemple maintenant bien connu du procédé Smartcut^{®} décrit dans l'article de M. BRUEL paru dans Electron. Letters, 31 (1995), page 1201.

Le principe de l'adhésion moléculaire permet de solidariser deux plaques sans apport de matière, ce qui présente un grand intérêt pour l'application visée par l'invention. Pour obtenir une adhésion entre deux plaques, il est nécessaire qu'elles présentent de bonnes propriétés de rugosité de surface, de chimie de surface (plaques hydrophiles pour un collage hydrophile ou plaques hydrophobes pour un collage hydrophobe), de planéité et de propreté (pas de poussières en surface). On peut se référer par exemple au document Semiconductor Wafer-Bonding : Science and Technology par U. GOESELE et Q. Y. TONG paru dans Electrochemical Society, édité par John Wiley and Sons, 1999.

Cependant, les plaques qui possèdent des composants électroniques présentent un relief qui ne permet pas d'obtenir les conditions requises pour obtenir une adhésion moléculaire. Pour obtenir les critères requis de rugosité et de relief, il est souvent nécessaire de préparer les surfaces à mettre en contact, par exemple au moyen d'une étape de planarisation par polissage mécano-chimique. Ces techniques de préparation sont particulièrement bien adaptées pour la mise en contact par exemple de surfaces en oxyde de silicium, en nitrure de silicium, ou en polysilicium (voir C. GUI et al., J. Electrochem. Soc. 144, 1997, page 237). Le relief de surface est éliminé de façon à obtenir le maximum de surface en contact afin d'avoir les forces de collage les plus fortes possible. Les structures ainsi obtenues sont solidarisées de façon irréversible. Les documents cités ci-dessus insistent sur la nécessité de planariser parfaitement les surfaces en contact sur toute la plaque pour obtenir une bonne adhésion. Les plaques sont dites parfaitement planarisées lorsqu'en tout point de la plaque la rugosité AFM (rms) est inférieure à ou de l'ordre de 0,5 nm. La rugosité mesurée en AFM (microscope à force atomique) correspond au relief mesuré par une pointe au contact de la surface sur un champ de 100 µm².

Cette parfaite planarisation est incompatible avec des plaques qui doivent conserver un relief, en particulier pour conserver des ouvertures au niveau des plots de contact des composants.

La méthode de collage par adhésion moléculaire est également utilisées dans d'autres domaines que la microélectronique, par exemple pour la fabrication de microcapteurs ou MEMS. Dans ces autres domaines, certains dispositifs sont réalisés à partir d'une solidarisation par adhésion moléculaire de plaques présentant un évidement local ou des cavités. On peut se référer à ce sujet à T. GESSNER et al., Proc. of second Internat. Symp. on microstructures and microfabricated systems (Elec. Soc. Inc. Pennington, NJ, USA, 1995), pages 297-308 (Chicago, IL, USA, 8-13 octobre 1995). Cependant, dans ces publications, les surfaces à solidariser sont préparées de telle façon que les forces de collage soient très importantes.

Il n'est jamais fait état dans la littérature technique de la possibilité de décoller des structures après adhésion lorsqu'une préparation par planarisation a été effectuée et que l'adhésion est suivie d'un traitement thermique de consolidation.

Par ailleurs, A. PLOSSL et al. signalent dans Materials Science and Engineering R: report, "Wafer Direct Bonding : Tailoring Adhésion Between Brittle Materials", page 54, que si des plaques sont solidarisées par collage hydrophile, un recuit ultérieur (par exemple à 100°C) rend difficile leur séparation.

D'autres travaux ont porté sur la possibilité de contrôler les forces de collage obtenues par adhésion moléculaire de plaques entières et sans relief. Ce contrôle des forces de collage permet d'obtenir un collage réversible par contrôle de la rugosité sur toute la surface de la plaque. C'est ce qui est divulgué dans le document FR-A-2 796 491. Si une plaque présente un relief, il faut entièrement planariser toute la surface de la plaque. Pour cela, le relief est éliminé et on cherche à obtenir une rugosité de surface inférieure ou de l'ordre de 0,5 nm en rms. Ensuite, la rugosité de surface est modifiée de façon homogène sur toute la surface de la plaque.

Le document FR-A-2 725 074, correspondant au brevet américain N°5 683 830, divulgue la possibilité de transférer des couches minces d'un premier substrat vers un deuxième substrat grâce au contrôle des forces de collage.

En résumé, l'art antérieur enseigne comment amincir une plaque en la collant sur une poignée de maintien par différents moyens. Cependant, l'art antérieur ne comprend aucun procédé permettant de coller de façon réversible une plaque, comprenant des composants et présentant un relief qui doit être en partie conservé, sur un support intermédiaire servant de poignée, ce collage devant permettre d'amincir la plaque et de manipuler la plaque amincie sur sa poignée.

Le document FR-A-2 781 925 divulgue un procédé de transfert sélectif d'éléments depuis un support de transfert vers un support de réception, les éléments adhérant par une première face au support de transfert selon une énergie d'adhésion définie, les éléments présentant chacun une seconde face susceptible d'être mise en contact avec le support de réception. Le transfert des éléments à transférer est obtenu en leur conférant une énergie d'adhésion avec le support de réception supérieure à l'énergie d'adhésion de leur première face avec le support de transfert, des moyens de retenue étant prévus pour retenir les éléments à ne pas transférer sur le support de transfert.

Le document US 2001/051 415 divulgue un procédé de fabrication d'un substrat semiconducteur mince à partir d'un substrat initial. Une couche mince est délimitée dans le substrat initial par une pluralité de vides. Au moins un composant électronique est formé dans la couche mince. Une parti de cette couche mince est ensuite séparée du reste du substrat initial.

Le document FR-A-2 809 867 divulgue un procédé de réalisation d'un substrat fragilisé comprenant une étape d'introduction d'au moins une espèce gazeuse dans une zone du substrat afin de former des microcavités dans cette zone, la zone ainsi fragilisée délimitant une couche mince avec une face du substrat, et une étape d'élimination de tout ou partie de l'espèce gazeuse de la zone fragilisée.

### EXPOSE DE L'INVENTION

L'invention permet de remédier au problème exposé ci-deseus.

Elle a pour objet un procédé d'obtention d'une couche mince à partir d'une plaque comprenant une face avant devisée en éléments de surface et présentant un relief donné comprenant des sommets, et une face arrière, comprenant les étapes consistant à :
a) se procurer une poignée support possédant une face servant de face de collage ;
b) préparer la face avant de la plaque, cette préparation comprenant une planification des sommets du relief dite planarisation incomplète de la face avant de la plaque, pour obtenir, par rapport à la face de collage de la poignée support, une énergie de collage E₀ comprise entre une première valeur, correspondant à l'énergie de collage minimum compatible avec l'étape postérieure d'amincissement, et une deuxième valeur, correspondant à l'énergie de collage maximale compatible avec l'opération postérieure de désolidarisation, l'énergie de collage E₀ étant telle que E₀ = α·E, E étant l'énergie de collage qui serait obtenue si la face avant de la plaque était complètement planarisée, α étant le rapport entre la surface planarisée incomplètement de la face avant de la plaque et la surface de la face avant de la plaque si elle était planarisée complètement et α étant compris entre 0,4 et 0,8;
c) solidariser, par adhésion moléculaire, la face avant de la plaque sur la face de collage de la poignée support ;
d) amincir la plaque à partir de sa face arrière jusqu'à obtenir la couche mince ;
e) reporter les éléments de surface de la couche mince sur un support d'utilisation, impliquant la désolidarisation d'avec la poignée support.

Selon une première application du procédé, à l'étape e), l'ensemble des éléments de surface est reporté sur le support d'utilisation,

Selon une deuxième application du procédé, à l'étape e), le report des éléments de surface se faisant de manière individuelle, l'étape b) est menée de façon à obtenir pour chaque élément de surface une énergie de collage E₀, l'étape e) étant précédée d'une étape de découpe de la couche mince en éléments de surface.

Selon une troisième application du procédé, à l'étape e), le report des éléments de surface se faisant par groupe d'éléments de surface, l'étape b) est menée de façon à obtenir pour chaque groupe d'éléments de surface une énergie de collage E₀, l'étape e) étant précédée d'une étape de découpe de la couche mince en groupe d'éléments de surface.

La découpe de la couche mince peut s'accompagner de la découpe de la poignée support.

L'étape de découpe peut s'effectuer en combinant une étape de gravure profonde de la couche mince et une étape de sciage.

La partie de la plaque destinée à fournir la couche mince peut notamment comprendre du matériau semiconducteur. Les éléments de surface peuvent constituer des composants électroniques achevés ou non.

A l'étape b), la planarisation incomplète peut être réalisée par une méthode de polissage mécano-chimique.

A l'étape d), l'amincissement de la plaque peut être réalisé par une méthode d'amincissement mécanique, chimique ou mécano-chimique.

A l'étape e), la désolidarisation d'avec la poignée support peut être réalisé en particulier par des moyens mécaniques et/ou pneumatiques.

A l'étape e), le report a lieu avant la désolidarisation d'avec la poignée support.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue en coupe transversale d'une poignée support destinée à la mise en oeuvre du procédé selon l'invention,
- la figure 2 est une vue en coupe transversale d'une plaque devant fournir une couche mince grâce au procédé selon l'invention,
- les figures 3A à 3F illustrent différentes étapes du procédé selon la présente invention.

### DESCRIPTION DETAILLEE DE MODES DE REALISATION DE L'INVENTION

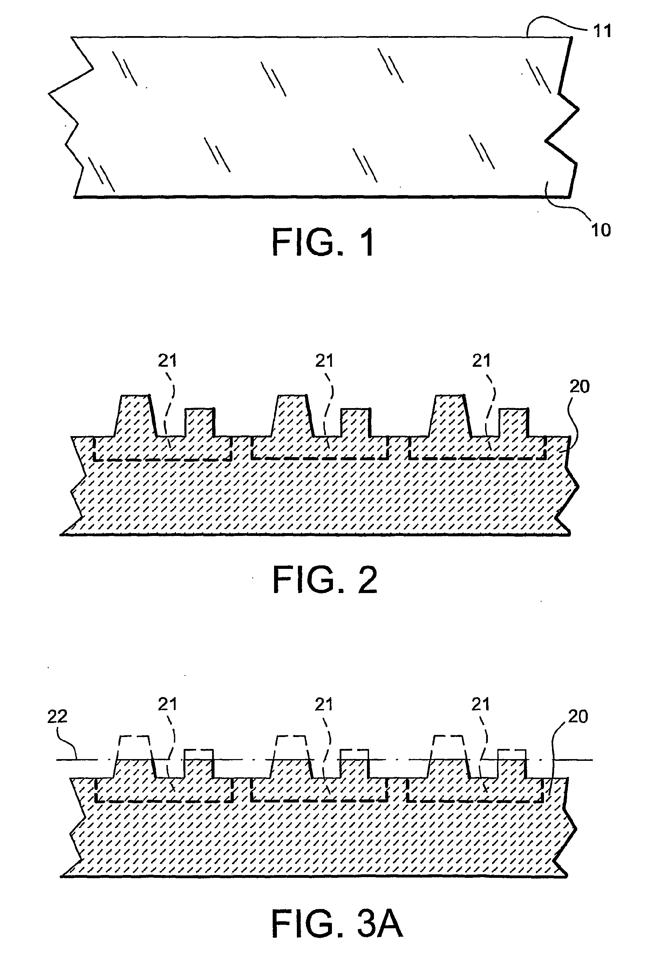

La figure 1 montre, en coupe transversale, une poignée support 10 constituée par exemple d'une plaque de silicium ou de verre. Le verre présente l'avantage d'être transparent, ce qui permet de contrôler visuellement les objets déposés sur la face arrière. La poignée support 10 présente une face 11 préparée pour servir de face de collage.

La figure 2 montre, en coupe transversale, une plaque 20 en matériau semiconducteur, par exemple en silicium. L'une de ses faces principales a subi des traitements destinés à réaliser des composants électroniques. La-figure 2, qui est une vue partielle, montre trois composants 21 achevés ou non. La présence de ces composants fait que la face plane traitée présente un relief important avec plusieurs zones de hauteurs différentes et de rugosités différentes. Lorsque la plaque comprend des composants terminés, une partie de ce relief correspond à la présence d'ouvertures permettant d'aller reprendre des contacts électriques.

D'une manière générale, la nature chimique des plaques à coller par adhérence moléculaire, les nettoyages chimiques avant collage et le traitement thermique de consolidation du collage sont fixés de telle façon qu'une énergie de collage E est obtenue si la plaque comprenant les composants est totalement planarisée. Une surface est totalement planarisée si sa rugosité est inférieure à environ 0,5 nm sur tout élément de 100 µm² de cette surface (mesure AFM).

Selon le procédé de l'invention, la plaque comprenant les composants est préparée puis collée sur la poignée support de façon à obtenir un collage par adhésion moléculaire avec une énergie de collage contrôlée E₀ telle que E₀ = α · E avec E₀ > E₁ et E0< E₂. E₁ est l'énergie de collage minimum qui est compatible avec l'amincissement. E₂ est l'énergie de collage maximum au-dessous de laquelle la solidarisation des pièces collées est réversible. Le coefficient α est avantageusement compris entre 0,4 et 0,8. Ce coefficient est le rapport entre la surface planarisée et la surface totale de la plaque. Pratiquement, la surface planarisée est égale à la somme des éléments de surface planarisés. On appelle élément de surface planarisé toute partie connexe de la surface où la rugosité mesurée en AFM est inférieure à environ 0,5 nm sur tout élément de 100 µm².

La solidarisation (ou collage) étant réalisée par adhésion moléculaire, il n'y a aucun ajout de matière à l'interface des deux pièces solidarisées. L'épaisseur totale des pièces collées n'est pas modifiée et l'amincissement peut être réalisé avec une grande précision. Cette précision dépend alors des équipements utilisés. Si un amincissement mécanique est réalisé, une précision de + ou - 1µm peut être obtenue.

Les figures 3A à 3D illustrent différentes étapes du procédé selon l'invention.

La figure 3A montre la plaque 20 après l'opération de planarisation effectuée jusqu'à atteindre le niveau 22. La planarisation est réalisée de façon préférentielle par polissage mécano-chimique (CMP) de façon à écrêter les sommets du relief suffisamment pour obtenir une adhésion moléculaire mais sans planariser totalement la plaque contrairement à la pratique habituelle. Il subsiste ainsi du relief sur la plaque sur plusieurs niveaux. Seulement deux niveaux sont représentés sur la figure 3A, mais plus de deux niveaux peuvent exister.

L'énergie de collage E₁ correspond à l'énergie minimum de collage qui permet un amincissement. Cette énergie minimum est bien sûr fonction de la méthode d'amincissement qui peut être mécanique, chimique, mécano-chimique ou autre. A titre d'exemple, E₁ vaut 500 mJ/m² pour un amincissement par rectification et polissage mécano-chimique.

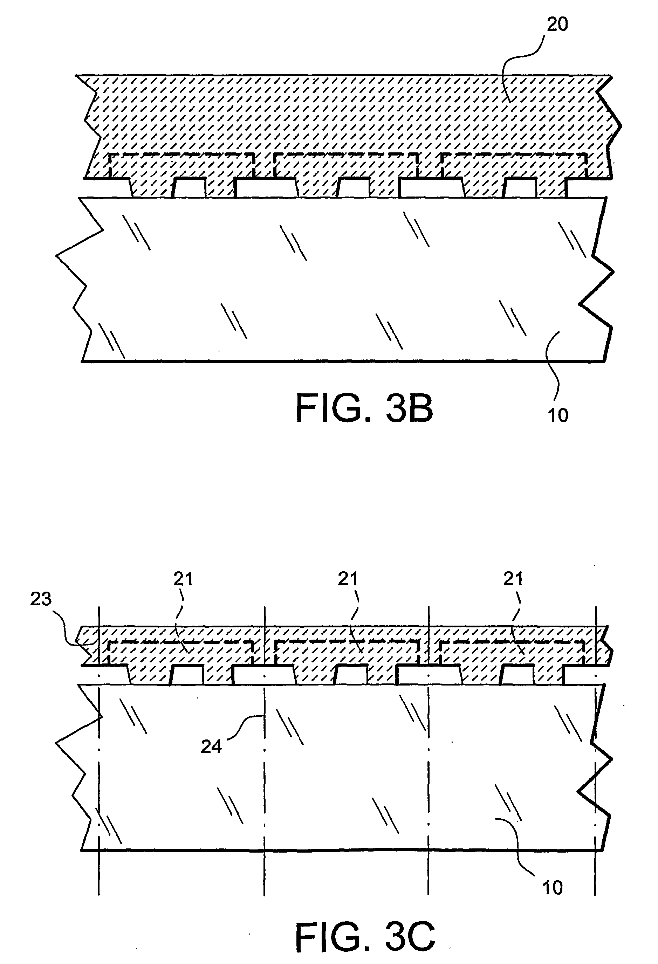

La figure 3B montre la structure obtenue lorsque la plaque 20 est solidarisée par adhésion moléculaire, côté composants, avec la poignée support 10. L'énergie de collage E dépend de la température à laquelle la structure a été éventuellement recuite, de la nature des matériaux qui sont mis en contact (Si₃N₄, SiO₂, Si...) et des nettoyage chimiques qui sont réalisés avant la mise en contact. Les traitements thermiques et chimiques sont, dans tous les cas, choisis de façon à ne pas dégrader la structure et en particulier les composants présents. Par exemple, pour un collage hydrophile de deux surfaces SiO₂ - SiO₂ totalement planarisées, une énergie de 1 J/m² est obtenue après un recuit à 300°C durant deux heures. L'énergie de collage E₂ est l'énergie de collage maximale au-dessous de laquelle la solidarisation est réversible. Elle dépend bien évidemment de la méthode qui est utilisée pour séparer les deux plaques au niveau de l'interface de collage après amincissement. Par exemple, si une lame est utilisée pour séparer les deux pièces de la structure, E₂ vaut environ 800 mJ/m² (les énergies de collage sont mesurées par la méthode de la lame).

La plaque 20, collée sur la poignée support 10, est amincie par sa face arrière pour fournir une couche mince 23. C'est ce que montre la figure 3C. Cet amincissement peut être mécanique : polissage ou rectification ("grinding" en anglais). Il peut être chimique : par gravure au moyen d'une solution qui attaque le matériau à amincir. Il peut aussi être mécano-chimique : par polissage mécano-chimique. Une couche d'arrêt peut également être présente dans le substrat initial (par exemple une couche d'oxyde enterrée dans le cas d'un substrat SOI). Dans ce cas, l'amincissement est réalisé jusqu'à cette couche d'arrêt.

Après amincissement, la couche mince solidarisée avec la poignée support peut être manipulée. Les composants de la couche mince peuvent alors être reportés de façon collective sur un autre support de même diamètre. Ils peuvent aussi être reportés individuellement. Dans le cas où un report individuel est demandé, les composants sont découpés sur leur poignée support. Sur la figure 3C, on a indiqué les axes de découpe 24 des composants 21.

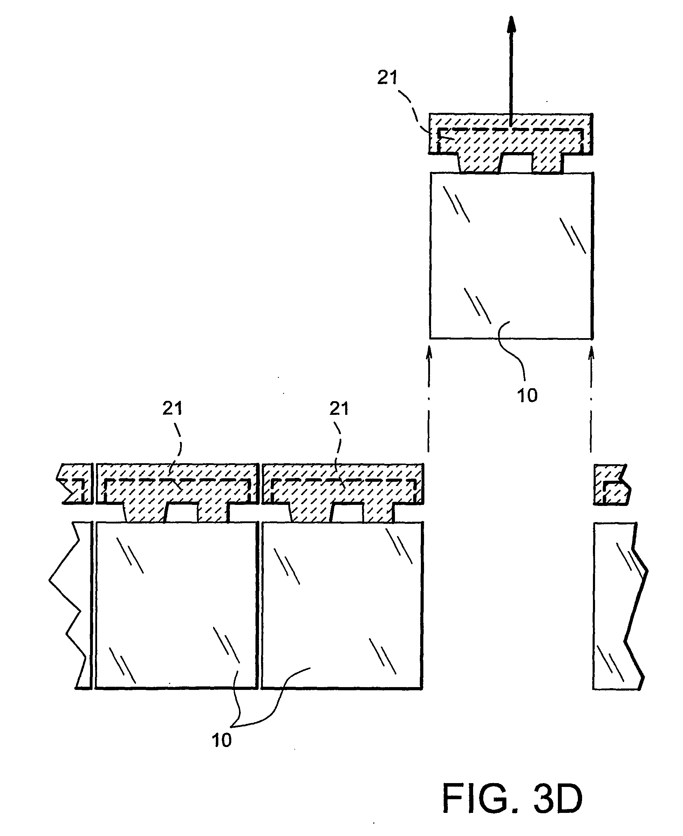

Sur la figure 3D, on a représenté les composants et leur support découpés. Ces composants découpés sont manipulables avec des outils classiques car les composants amincis sont sur leur support de manipulation. La figure 3D montre un composant 21 et la partie de la poignée support 10 qui lui correspond, en cours de manipulation.

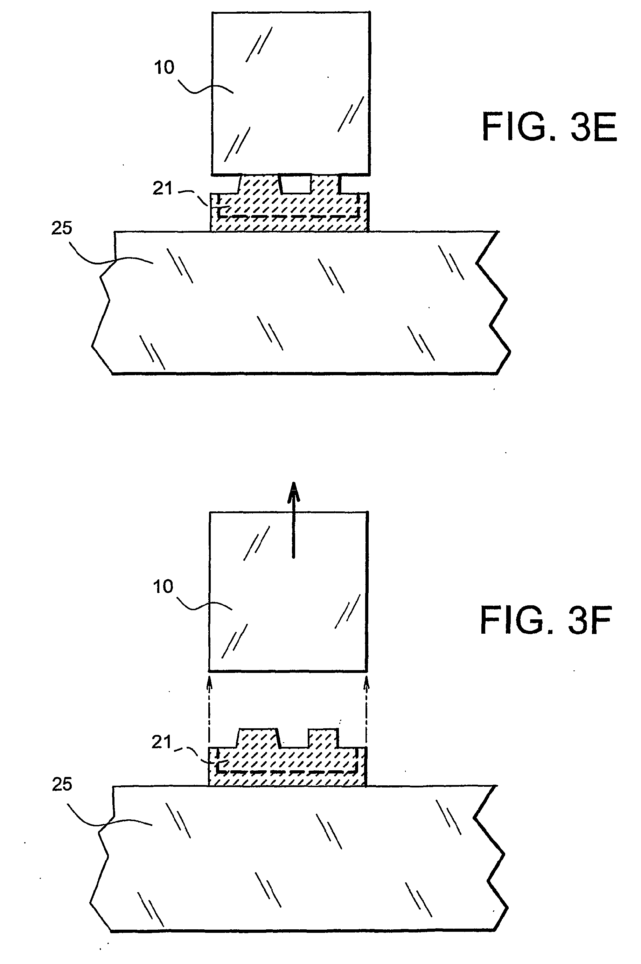

Une fois que le ou les composants sont reportés sur leur support final ou sur un autre support intermédiaire, il faut pouvoir séparer le ou les composants de leur partie de poignée support. La figure 3E représente un composant 21 reporté sur son support final 25, le composant 21 étant toujours solidaire de sa partie de poignée support 10. La figure 3F représente le composant 21 fixé sur son support final 25 et séparé de sa partie de poignée support 10. La séparation peut être effectuée par tout moyen mécanique ou pneumatique utilisé seul ou en combinaison. On peut citer la séparation par insertion d'un outil (lame en Téflon^{®}, métallique), par injection d'un flux gazeux, en exerçant une force de traction et/ou de cisaillement.

Une variante du procédé consiste à découper seulement la couche mince contenant les éléments à reporter ou seulement cette couche et une partie de la poignée. Le prélèvement de l'élément à reporter est alors simultané de la séparation entre l'élément et la poignée support. Un manipulateur (par exemple une micropipette à vide) est utilisé pour reporter l'élément.

Dans une autre variante, le composant peut être séparé de la poignée support pendant le report. C'est le cas lorsqu'est utilisé un pointeau à travers une poignée support trouée.

L'invention s'applique à l'amincissement de tout type de semiconducteur, par exemple le silicium, le germanium, les semiconducteurs III-V (AsGa, InP, GaN)... Elle s'applique également au cas où la plaque est en matériau quelconque mais qui peut être aminci.

On va détailler maintenant le cas d'une plaque comportant en surface des circuits intégrés dont les plots de contact sont ouverts et dont les caractéristiques électriques ont été testées à l'aide d'un testeur standard. Cette plaque présente un fort relief en surface. Dans le cas, où l'amincissement doit être bien contrôlé, la plaque est mesurée précisément, avant amincissement, afin de bien connaître les épaisseurs en tout point de cette plaque (par exemple par ADE).

La plaque est planarisée de façon incomplète de façon à écrêter les sommets du relief et obtenir des plateaux dont la surface fait environ 2 mm² et dont la rugosité sur cette surface est inférieure à 0,5 nm. Cette surface est par exemple en oxyde de silicium ou en nitrure de silicium. La surface planarisée représente 60% de la surface totale. La planarisation est réalisée par CMP et, après nettoyage chimique, la plaque est mise en contact avec sa poignée support qui peut être une plaque de silicium oxydée en surface ou une plaque de verre avec éventuellement un dépôt d'oxyde de silicium en surface. Un recuit à 250°C pendant deux heures est réalisé pour cette plaque afin d'obtenir une énergie de collage de l'ordre de 600 mJ/m². Il est également possible de chauffer à une température plus basse et plus longtemps ou inversement pour obtenir une énergie de collage du même ordre de grandeur.

La face arrière de la plaque contenant les circuits intégrés est amincie jusqu'à une épaisseur de 10 µm, par exemple par rectification suivie d'un polissage mécano-chimique. Les circuits sont ensuite découpés sur leur poignée support au moyen d'une scie standard. Une variante consiste à réaliser une gravure profonde de la couche mince portant les composants selon un motif tel qu'il facilite le sciage, par exemple une gravure de toute la couche mince sur une longueur supérieure au trait de scie. On manipule l'ensemble avec des outils standard de "pick and place". Un circuit peut alors être reporté par exemple sur une carte à puce en collant la face arrière du circuit sur le support final avec une colle. Ensuite, une traction est exercée de façon à séparer la face avant du circuit de la poignée support.

Suivant une autre variante de réalisation, la face arrière du circuit est collée par adhésion moléculaire sur une plaquette contenant d'autres circuits afin de réaliser des circuits 3D. La solidarisation de la face arrière du circuit peut se faire avec une énergie de collage par exemple de 1,5 J/m². Une telle énergie peut être obtenue grâce à un nettoyage plasma. Le support intermédiaire peut être éliminé par introduction d'une lame à l'interface de collage. Un petit évidement peut avoir été prévu au niveau de l'interface pour faciliter l'introduction de la lame.

## Revendications

1. Procédé d'obtention d'une couche mince (23) à partir d'une plaque (20) comprenant une face avant divisée en éléments de surface et présentant un relief donné comprenant des sommets, et une face arrière, comprenant les étapes consistant à :
a) se procurer une poignée support (10) possédant une face (11) servant de face de collage ;
b) préparer la face avant de la plaque (20), cette préparation comprenant une planification des sommets du relief dite planarisation incomplète de la face avant de la plaque, pour obtenir, par rapport à la face de collage (11) de la poignée support (10), une énergie de collage E₀ comprise entre une première valeur, correspondant à l'énergie de collage minimum compatible avec l'étape postérieure d'amincissement, et une deuxième valeur, correspondant à l'énergie de collage maximale compatible avec l'opération postérieure de désolidarisation, l'énergie de collage E₀ étant telle que E₀ = α·E, E état l'énergie de collage qui serait obtenue si la face avant de à plaque était complètement planarisée, α étant le rapport entre la surface planarisée incomplètement de la face avant de la plaque et la surface de la face avant de la plaque si elle était planarisée complètement et α étant compris entre 0,4 et 0,8;
c) solidariser, par adhésion moléculaire, la face avant de la plaque (20) sur la face de collage (11) de la poignée support (10) ;
d) amincir la plaque (20) à partir de sa face arrière jusqu'à obtenir la couche mince (23) ;
e) reporter les éléments de surface de la couche mince sur un support d'utilisation, impliquant la désolidarisation d'avec la poignée support.

2. Procédé selon la revendication 1, **caractérisé en ce que**, à l'étape e), l'ensemble des éléments de surface est reporté sur le support d'utilisation.

3. Procédé selon la revendication 1, **caractérisé en ce que**, à l'étape e), le report des éléments de surface se faisant de manière individuelle, l'étape b) est menée de façon à obtenir pour chaque élément de surface une énergie de collage E₀, l'étape e) étant précédée d'une étape de découpe de la couche mince en éléments de surface.

4. Procédé selon la revendication 1, **caractérisé en ce que**, à l'étape e), le report des éléments de surface se faisant par groupe d'éléments de surface, l'étape b) est menée de façon à obtenir pour chaque groupe d'éléments de surface une énergie de collage E₀, l'étape e) étant précédée d'une étape de découpe de la couche mince en groupe d'éléments de surface.

5. Procédé selon l'une des revendications 3 ou 4, **caractérisé en ce que** la découpe de la couche mince s'accompagne de la découpe de la poignée support.

6. Procédé selon l'une quelconque des revendications 3 à 5, **caractérisé en ce que** l'étape de découpe s'effectue en combinant une étape de gravure profonde de la couche mince et une étape de sciage.

7. Procédé selon l'une quelconque des revendications 1 à 6, **caractérisé en ce que** la partie de la plaque destinée à fournir la couche mince comprend du matériau semiconducteur.

8. Procédé selon la revendication 7, **caractérisé en ce que** les éléments de surface constituent des composants électroniques achevés ou non.

9. Procédé selon l'une quelconque des revendications 1 à 8, **caractérisé en ce que**, à l'étape b), la planarisation incomplète est réalisée par une méthode de polissage mécano-chimique.

10. Procédé selon l'une quelconque des revendications 1 à 9, **caractérisé en ce que**, à l'étape d) , l'amincissement de la plaqué est réalisé par une méthode d'amincissement mécanique, chimique ou mécano-chimique.

11. procédé selon l'une quelconque des revendications 1 à 10, **caractérisé en ce que**, à l'étape e), la désolidarisation d'avec la poignée support est réalisé par des moyens mécaniques et/ou pneumatiques.

12. Procédé selon l'une quelconque des revendications 1 à 11, **caractérisé en ce que**, à l'étape e), le report a lieu avant la désolidariation d'avec la poignée support.

## Claims

1. Method for making a thin layer (23) starting from a wafer (20) comprising a front face divided into surface elements and with a given relief comprising vertices, and a back face, comprising steps consisting of:
a) obtaining a support handle (10) with a face (11) acting as a bonding face;
b) preparing the front face of the wafer (20), this preparation including planarisation of the vertices of the relief called incomplete planarisation of the front face of the wafer, to obtain a bonding energy E₀ with the bonding face (11) of the support handle (10), between a first value corresponding to the minimum bonding energy compatible with the later thinning step, and a second value corresponding to the maximum bonding energy compatible with the subsequent desolidarisation operation, the bonding energy E₀ being such that E₀ = α.E, where E is the bonding energy that would be obtained if the front face of the wafer was completely planarised, α is the ratio between the incompletely planarised surface of the front face of the wafer and the surface of the front face of the wafer if it were completely planarised, α being between 0.4 and 0.8 ;
c) solidarising the front face of the wafer (20) on the bonding face (11) of the support handle (10), by direct bonding;
d) thinning the wafer (20) starting from its back face until the thin layer (23) is obtained;
e) transferring the surface elements from the thin layer onto a usage support, involving separation from the support handle.

2. Method according to claim 1, **characterised in that** all surface elements are transferred onto the usage support in step e).

3. Method according to claim 1, **characterised in that** surface elements are transferred individually in step e), step b) is carried out so as to obtain a bonding energy E₀ for each surface element, step e) being preceded by a step in which the thin layer is cut into surface elements.

4. Method according to claim 1, **characterised in that** the surface elements are transferred by groups of surface elements in step e), step b) is carried out so as to obtain a bonding energy E₀ for each group of surface elements, step e) being preceded by a step in which the thin layer is cut into groups of surface elements.

5. Method according to either claim 3 or 4, **characterised in that** the support handle is cut at the same time as the thin layer is cut.

6. Method according to any one of claims 3 to 5, **characterised in that** the cutting step is made by combining a deep etching step of the thin layer and a sawing step.

7. Method according to any one of claims 1 to 6, **characterised in that** the part of the wafer from which the thin layer will be obtained includes semiconducting material.

8. Method according to claim 7, **characterised in that** the surface elements are composed of complete or incomplete electronic components.

9. Method according to any one of claims 1 to 8, **characterised in that** in step b), the incomplete planarisation is done by a mechanical-chemical polishing method.

10. Method according to any one of claims 1 to 9, **characterised in that** in step d), the wafer is thinned by a mechanical, chemical or mechanical-chemical thinning method.

11. Method according to any one of claims 1 to 10, **characterised in that** in step e), separation from the support handle is achieved by mechanical and / or pneumatic means.

12. Method according to any one of claims 1 to 11, **characterised in that** in step e), the transfer takes place before separation from the support handle.

## Patentansprüche

1. Verfahren zur Gerinnung einer dünnen Schicht (23) aus einer Platte (20), enthaltend eine vordere Fläche, die in Oberflächenelemente unterteilt ist und die ein gegebenes Relief mit Erhebungen und eine rückwärtige Fläche zeigt, welches die Stufen umfasst, die bestehen aus:
a) Bereitstellung eines Trägers (10), mit einer Fläche, die als Haftfläche dient;
b) Herstellung der vorderen Fläche der Platte (20), wobei diese Herstellung die Einebnung des Reliefs als unvollständige Einebnung der vorderen Fläche der Platte umfasst, um, bezogen auf die Haftfläche des Trägers (10) eine Haftenergie Eo zu erhalten, die zwischen einem ersten Wert, welcher der minimalen Haftenergie, die mit dem anschließenden Schritt der Verdünnung verträglich ist, und einem zweiten Wert liegt, welcher der maximalen Haftenergie, die mit der anschließenden Operation der Aufweichung verträglich ist, entspricht, wobei die Haftenergie der Beziehung Eo=aE entspricht, wobei E die Haftenergie, die erhalten wird, wenn die vordere Fläche der Platte eingeebnet ist, und a das Verhältnis zwischen der unvollständig eingeebneten vorderen Fläche der Platte und der vollständig eingeebneten vorderen Fläche der Platte bedeutet und wobei a zwischen 0,4 und 0,8 liegt;
c) Vereinigung der vorderen Fläche der Platte mit der Haftfläche (11) des Trägers (10) durch molekulare Haftung;
d) Verdünnung der Platte (20), ausgehend von ihrer rückwärtigen Fläche, bis eine dünne Schicht (23) erhalten wird;
e) Übertragung der Oberflächenelemente auf einen Gebrauchsträger, wobei die Trennung von dem Träger erfolgt.

2. Verfahren nach Anspruch 1, **dadurch gekennzeichnet, dass** auf der Stufe e) die Gesamtheit der Oberflächenelemente auf den Gebrauchsträger übertragen wird.

3. Verfahren nach Anspruch 1, **dadurch gekennzeichnet, dass** auf der Stufe e) das Verhältnis der Oberflächenelemente individuell gestaltet ist, die Stufe b) so ausgestaltet ist, dass für jedes Oberflächenelement eine Haftenergie E0 erhalten wird und der Stufe e) eine Stufe vorausgeht, auf der die dünnen Schicht in Oberflächenelemente zerschnitten wird.

4. Verfahren nach Anspruch 1, **dadurch gekennzeichnet, dass** auf der Stufe e) das Verhältnis der Oberflächenelemente durch Gruppen von Oberflächenelementen dargestellt wird, die Stufe b) so ausgestaltet wird, dass für jede Gruppe von Oberflächenelementen eine Haftenergie Eo erhalten wird und der Stufe e) eine Stufe vorausgeht, auf der die dünne Schicht in eine Gruppe von Oberflächenelementen zerschnitten wird.

5. Verfahren nach einem der Ansprüche 3 oder 4, **dadurch** gekenntzeichnet, dass das Zerschneiden der dünnen Schicht zusammen mit dem Zerschneiden des Trägers erfolgt.

6. Verfahren nach einem der Ansprüche 3 bis 5, **dadurch gekennzeichnet, dass** die Stufe des Zerschneidens in Kombination mit einer Stufe der Tiefengravur der dünnen Schicht und einer Stufe des Sägens durchgeführt wird.

7. Verfahren nach einem der Ansprüche 1 bis 6, **dadurch gekennzeichnet, dass** der Teil der Platte, der zur Bereitstellung der dünnen Schicht bestimmt ist, ein Halbleitermaterial darstellt.

8. Verfahren nach Anspruch 7, **dadurch gekennzeichnet, dass** die Oberflächenelemente vollständige oder unvollständige elektronische Komponenten darstellen.

9. Verfahren nach einem der Ansprüche 1 bis 8, **dadurch gekennzeichnet, dass** auf der Stufe b) die unvollständige Einebnung durch ein mechanisch-chemisches Polierverfahren durchgeführt wird.

10. Verfahren nach einem der Ansprüche 1 bis 9, **dadurch gekennzeichnet, dass** auf der Stufe b) die Verdünnung der Platte durch ein mechanisches, chemisches oder mechanisch-chemisches Verdünnungsverfahren durchgeführt wird.

11. Verfahren nach einem der Ansprüche 1 bis 10, **dadurch gekennzeichnet, dass** auf der Stufe e) die Entfernung vom Träger durch mechanische und/oder pneumatische Mittel durchgeführt wird.

12. Verfahren nach einem der Ansprüche 1 bis 11, **dadurch gekennzeichnet, dass** auf der Stufe e) die Übertragung vor der Trennung vom Träger durchgeführt wird.
